# EUROPEAN PATENT APPLICATION

(11) **EP 1 657 755 A1**
(43) Date of publication of application: **17.05.2006**
(21) Application number: 04771984.4
(22) Date of filing: 20.08.2004
(51) Int. Cl.: H01L 29/737

(54) **ELECTRIC POWER TRANSFORMING APPARATUS**

(30) Priority: 22.08.2003 JP 2003298089
(71) Applicant: MITSUBISHI HEAVY INDUSTRIES, LTD., Tokyo 108-8215 (JP)
(72) Inventor: Kawabata, Osamu, Mitsubishi Heavy Industries, Ltd., Tokyo 108-8215 (JP); Nakano, Koji, Mitsubishi Heavy Industries, Ltd., Nakamra-ku, Nagoya-shi, Aichi 453-0862 (JP); Utsumi, Jun, Mitusbishi Heavy Industries, Ltd., Yokohama-shi, Kanagawa 236-0003 (JP)
(74) Representative: Henkel, Feiler & Hänzel
(86) International application number: PCT/JP2004/012023
(87) International publication number: WO 2005/020331

(57) **Abstract**

A power converter is composed of a switching circuit including a bipolar transistor for switching a DC power input. A SiGe heterobipolar transistor is used as the aforementioned bipolar transistor. The high speed switching characteristics of the SiGe heterobipolar transistor effectively reduces loss of the power converter.

## Description

### Technical Field

The present invention relates to power converters such as power supplies, battery chargers, DC/DC converters, AC/DC converters, AC adapters, and pulse power generator circuits.

### Background Art

Power converters that convert DC power input or AC power input into DC output are utilized in many instruments such as information equipment including mobile information gadgets, home electric appliances, lighting fixtures, and liquid crystal displays. For example, power converters are connected to a 100-V or 200-V AC commercial power source and used for supplying 10- to 20-V DC power to personal computers, battery chargers for cellular phones, and home electric appliances.

One requirement on these power converters is electrical isolation between input and output. For instance, an AC commercial power source and end equipment of power are required to be electrically isolated for safety necessity and so that the commercial power network does not suffer from influence when any of the end equipment of power causes a ground fault; the ground relay set in the commercial power network is required not to operate even if the end equipment of power causes a ground fault. For this isolation, a high-frequency transformer compatible with the switching frequency is employed generally. Incidentally, some pulse power generator may not contain a high-frequency transformer.

One circuit topology achieving electrical isolation between input and output is the forward converter. A forward converter is disclosed in, for example, Haruo Togawa, "Hardware Design Series (Handbook for Practical Power Supply Circuit Design)", the 22nd edition, CQ Publishing Co., Ltd., August 1, 2003, p. 76.

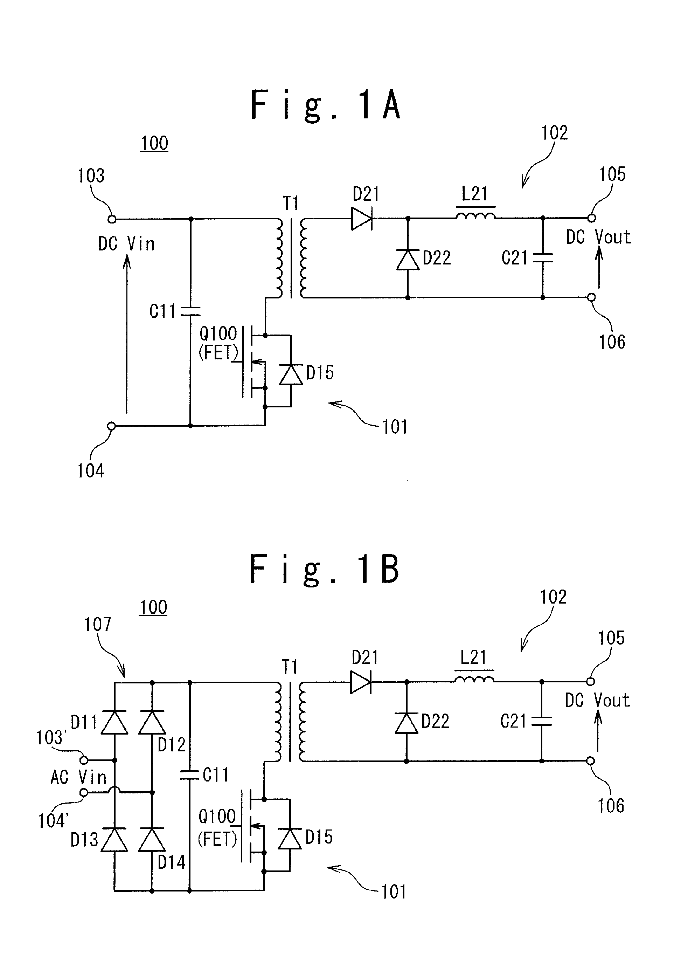

Fig. 1A is a circuit diagram showing a structure of a typical forward converter. A conventional forward converter 100 is composed of a switching circuit 101, a transformer T1, and a rectifying and smoothing circuit 102.

The switching circuit 101 includes input terminals 103 and 104, a capacitor C11, a field-effect transistor Q100, and a diode D15. The input terminals 103 and 104 are connected to a DC power supply (not shown) and receive DC power supply input Vᵢₙ. The input terminal 103 is connected to one terminal of a primary winding of the transformer T1, and the input terminal 104 is connected to the source of the transistor Q100. The drain of the transistor Q100 is connected to the other terminal of the primary winding of the transformer T1. The diode D15 is connected in parallel with the transistor Q100.

The transistor Q100 generates a rectangular wave by switching the DC power supply input Vᵢₙ. The rectangular wave generated by the transistor Q100 is supplied to the primary winding of the transformer T1.

The diode D15 provides the protection for the transistor Q100; the diode D15 is turned on to allow a current to flow therethrough when a reverse voltage is applied to the transistor Q100.

The capacitor C11 has two roles: the capacitor C11 functions as a smoothing capacitor for smoothing the DC power supply input Vᵢₙ. Furthermore, the capacitor C11 functions as the energy storage which supplies the transistor Q100 with a current for compensating the delay of the current generated immediately after the turn-on of the transistor Q100 from the DC power supply to the transistor Q100, the delay occurring within the DC power supply and by inductances of the wirings.

The transformer T1 receives the rectangular wave from the transistor Q100 at the primary winding, and outputs a rectangular wave with a voltage level in accordance with its transformation ratio from its secondary winding. The rectangular wave output from the transformer T1 is supplied to the rectifying and smoothing circuit 102.

The rectifying and smoothing circuit 102 is composed of diodes D21 and D22, a reactor L21, a capacitor C21, output terminals 105 and 106 outputting a DC output voltage Vₒᵤₜ. The diodes D21 and D22 are used to rectify the rectangular wave from the transformer T1, and the reactor L21 and the capacitor C21 are used to smooth the rectified rectangular wave. Specifically, the diode D21 allows the rectangular wave current from the secondary winding of the transformer T1 to flow through the reactor L21 and the capacitor C21, when the transistor Q100 is at on-state. The diode D22 supplies the energy stored across the reactor L21 to the capacitor C21 and thereby smoothes the output voltage Vₒᵤₜ, when the transistor Q100 is at off state. In the case where a pulse output is requested for the output voltage Vₒᵤₜ, the capacitor C21 is often omitted.

If an AC power supply input is available in place of a DC power supply input, a full-wave rectifier circuit 107 composed of diodes D11 to D14 may be connected to the input of the switching circuit 101, as shown in Fig. 1B; input terminals for receiving AC power supply input are denoted by numerals 103' and 104'. The full-wave rectifier circuit 107 converts the AC power supply input into DC power. The power converter circuit 100 generates the DC output voltage Vₒᵤₜ from the DC power.

In such a power converter, it is important to reduce power losses. Power converters are used in many instruments, and thus power losses in the power converters will lead to stupendous power losses on a society basis even if a loss in each individual instrument is nothing but several watts. Reducing power losses in power converters provides an extremely significant contribution to the improvement of the global environment. In addition to that, the reduction of power losses can downsize power converters; reducing power losses permits cooling mechanisms, such as radiating fins, to be smaller.

On this account, various approaches have been proposed for the reduction of power losses in power converters; the proposed approaches include improvements in control methods and in the existing power transistors. These conventional approaches, however, face limits of power consumption reduction within power converters.

One obstacle to reduction of power losses in power converters is the performance of switching transistors. As a switching transistor, a field-effect transistor (FET) is typically employed; however, the switching FET has a high on-resistance and therefore has a high source-drain voltage (on-voltage) at on-state. In addition, the switching FET suffers from long switching time, that is, time of duration necessary for switching between the on and off states.

For example, the performance of a typical switching FET used in a power converter working on a 142-V DC input voltage (that is, the maximum voltage obtained by full-wave rectifying a 100-V AC voltage) is as follows:
1) Rated drain-source current: 2.0A
2) Rated drain-to-source withstand voltage: 400V
3) Drain-to-source on-resistance: 3.6Ω
4) Turn-on time: 9.9 ns
5) Turn-off time: 11 ns
It should be noted that the above performances are on condition of the device area of 1 mm². Furthermore, the values of the on-resistance, turn-on time and turn-off time are on condition of a junction temperature of 100°C and a gate voltage of 10V; if the gate voltage is lower than 10 V, the on-resistance, turn-on time and turn-off time are further increased. The rated current is set to 2A because of a design requirement so that the junction temperature can be kept at the rated temperature of 150°C or less with sufficient margin. The withstand voltage is higher than the input DC voltage for the following reason: a steep overvoltage called switching surge is applied to the switching FET when the switching FET is turned off. In most cases, the switching FET is selected so as to withstand a switching surge by itself; it is not preferable to use a surge absorber to the switching FET due to the occurrence of loss. Generally, the switching FET is chosen so as to have a withstand voltage about twice as high as an input DC voltage.

In the case where the input current is 1 A, the typical switching FET's on-resistance of 3.6 Ω undesirably increases the on-voltage up to 3.6 V. This generates an undesirably large power loss. Besides, undesirably large turn-on time and turn-off time of the switching FET would aggravate the power loss.

As a switching transistor, an insulated gate bipolar transistor (IGBT) may be used in place of an FET. The circumstances described above are the same on the IGBT. The switching time of an IGBT is much larger than that of an FET, resulting in a greater switching loss.

As stated above, in the conventional approaches, since the switching transistor suffers from a large loss and is insufficient in switching speed, the switching frequency of the power converter is limited to several hundred kHz, which is 90% at most efficient on the whole; in other words, there is a loss of 10% at least. Due to the loss of 10%, large-sized cooling equipment is required to cool the switching transistor.

Therefore, there is a need to provide a power converter with high efficiency.

Other arts related to the present invention are disclosed in the following documents.

United States Patent No. 6,423,989, the whole disclosure which is incorporated herein by reference, and the corresponding Japanese Laid-open Patent Application No. P2001-338928A disclose the structure and manufacturing method of a SiGe hetero bipolar transistor.

Japanese Laid-open Patent Application No. P2002-299602A discloses a bipolar transistor which suppresses the Kirk effect, which inhibits the increase of a current gain, with high withstand voltage.

### Disclosure of Invention

An object of the present invention is to provide a power converter with high efficiency.

To accomplish this purpose, the present invention employs a SiGe hetero bipolar transistor (hereinafter referred to as SiGe transistor) as a switching transistor. The high-speed switching characteristics of the SiGe transistor effectively reduce a power loss in the power converter.

Conventionally, it has been not conceived to apply a SiGe transistor to a power converter as far as the inventor knows. This may be because the SiGe transistor is of high speed but suffers from the low withstand voltage and current gain; the low withstand voltage and current gain are not preferable in principle for application to a power converter. SiGe transistors are most typically used as amplifiers of high-frequency signals in the GHz band within cellular phones, due to the high-speed switching capability. In such applications, low internal noise is most important, while increased withstand voltage and current gain are not so important. Accordingly, researches and developments of the SiGe transistor have been focused on reducing internal noise in general.

However, the inventors have found out that the problems of low withstand voltage and current gain can be overcome by optimization of the structure of the SiGe transistor at the expense of internal noise. In other words, the inventors have discovered that the SiGe transistor can offer compatibility among high-speed switching capability, high withstand voltage, and high current gain, and thereby the inventor has come to conceive the present invention.

More specifically, a power converter according to the present invention is composed of a switching circuit with a bipolar transistor for switching a DC power supply input. A base layer of the bipolar transistor includes a SiGe layer.

Preferably, the power converter further includes a rectifier circuit, and a transformer having a primary winding connected to the switching circuit, and a secondary winding connected to the rectifier circuit. In this case, the power converter may further include another rectifier circuit which receive an AC power supply input, and provides the DC power supply input.

In a preferred embodiment, the switching circuit includes an input terminal for receiving the DC power supply input. The bipolar transistor is installed between the primary winding and the input terminal, and provides an electrical connection between the primary winding and the input terminal in response to a control signal.

Preferably, the power converter further includes a diode connected between a collector and an emitter of the bipolar transistor.

In a preferred embodiment, the base layer of the bipolar transistor includes a Si layer coupled to an emitter layer of the bipolar transistor. The SiGe layer is installed between the Si layer and the collector layer of the bipolar transistor. In this case, the Ge concentration of the SiGe layer preferably ranges from 6 to 16 mol %. Moreover, the base layer preferably has a thickness of 100 to 400 nm, and the collector layer preferably has a thickness of 20 to 90 µm.

In another preferred embodiment, the SiGe layer includes a first SiGe layer connected to the emitter layer of the bipolar transistor, and a second SiGe layer disposed between the first SiGe layer and the collector layer of the bipolar transistor. The Ge concentration of the first SiGe layer is lower than the Ge concentration of the second SiGe layer. In this case, the Ge concentration of the second layer preferably ranges from 6 to 16 mol %. Furthermore, the base layer preferably has a thickness of 100 to 400 nm, and the collector layer preferably has a thickness of 20 to 90 µm.

In still another preferred embodiment, the Ge concentration of the SiGe layer increases with the distance from the emitter layer. In this case, a peak value of Ge concentration of the SiGe layer preferably ranges from 6 to 16%. Moreover, the base layer preferably has a thickness of 100 to 400 nm, and the collector layer preferably has a thickness of 20 to 90 µm.

Such a structure of the power converter may be applied to a power conversion unit which includes a plurality of power conversion circuits sharing an external input terminal for receiving external power supply input.

### Brief Description of the Drawings

Fig. 1A is a circuit diagram showing a structure of a conventional forward converter generating DC voltage from DC power supply input;
Fig. 1B is a circuit diagram showing a structure of a conventional forward converter generating DC voltage from AC power supply input;
Fig. 2A is a circuit diagram showing a structure of a power converter in one embodiment of the present invention;
Fig. 2B is a circuit diagram showing another structure of the power converter in one embodiment of the present invention;
Fig. 3 is a cross-sectional view showing a structure of a SiGe transistor incorporated in the power converter in one embodiment of the present invention;
Fig. 4 is a graph showing a dopant profile and a Ge profile inside the SiGe transistor in one embodiment of the present invention;
Fig. 5 is a graph showing a dopant profile and a Ge profile inside the SiGe transistor in another embodiment of the present invention;
Fig. 6 is a graph showing a relationship between the Ge concentration and current gain of a SiGe layer included in a base layer;
Fig. 7 is a graph showing a relationship between the collector layer thickness and current gain;
Fig. 8 is a cross-sectional view showing another structure of the SiGe transistor;
Fig. 9A is a graph showing a waveform of a current through a switching FET;
Fig. 9B is a graph showing a waveform of a current through the SiGe transistor in the embodiments;
Fig. 10A is a circuit diagram showing another circuit topology to which the present invention is applicable; and
Fig. 10B is a circuit diagram showing still another circuit topology to which the present invention is applicable.

### Best Mode for Carrying Out the Invention

The embodiments of the present invention will be described hereinafter with reference to the accompanying drawings. It is to be noted that the same or corresponding numerals denotes the same, similar, or corresponding components in the drawings.

### Structure of Power Converter

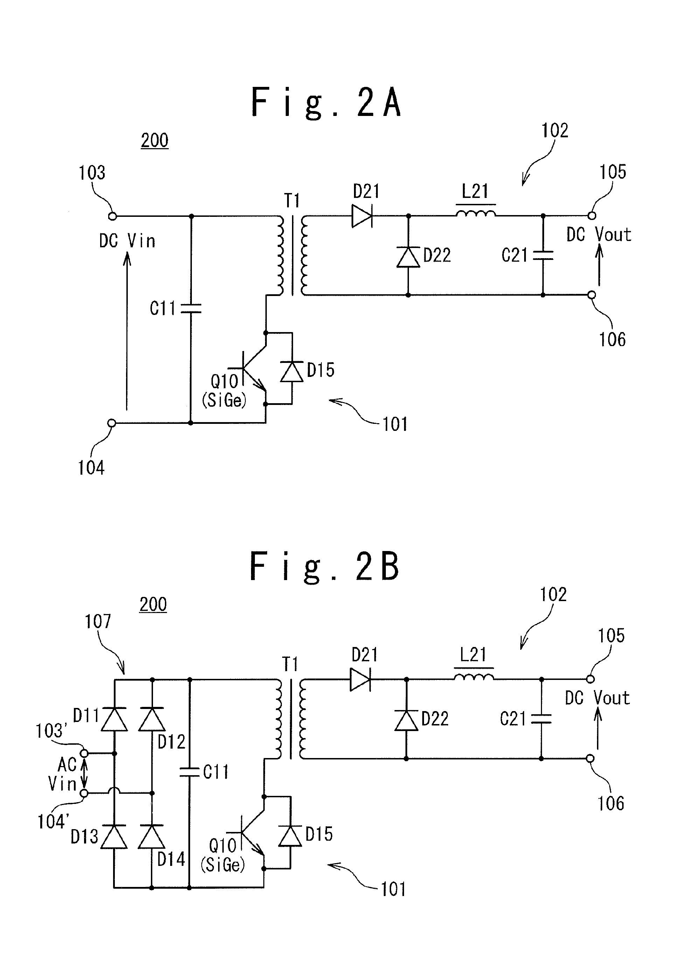

Fig. 2A is a circuit diagram showing a structure of a power converter 200 in one embodiment of the present invention. The power converter 200 is designed to convert a DC power supply input Vᵢₙ into a DC output voltage Vₒᵤₜ, and the input and output are isolated from each other by a transformer T1.

The structure of the power converter 200 is basically similar to the structure of the conventional forward converter 100 in Fig. 1A; the difference is that a SiGe transistor Q10 is used as a switching transistor, which includes a SiGe layer within a base layer. The use of the SiGe transistor Q10 increases the switching frequency, and effectively reduces the power loss in the power converter 200. The SiGe transistor Q10 is increased in withstand voltage and current gain by optimization of the structure, and is also decreased in the collector-to-emitter voltage at on-state. This enables the power converter 200 to be enhanced in efficiency and reliability; the optimization of structure of the SiGe transistor Q10 will be described later in detail. The improvement in the efficiency of the power converter 200 is also effective 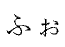 r downsizing and reducing costs of the power converter 200.

More specifically, the power converter 200 of this embodiment is composed of a switching circuit 201, a transformer T1, and a rectifying and smoothing circuit 102.

The switching circuit 201 includes input terminals 103 and 104, a capacitor C11, a SiGe transistor Q100, and a diode D15. The input terminals 103 and 104 are connected to a DC power supply (not shown) and receive a DC power supply input Vᵢₙ. The input terminal 103 is connected to one terminal of the primary winding of the transformer T1. The input terminal 104 is connected to the emitter of the SiGe transistor Q100. The collector of the SiGe transistor Q10 is connected to the other terminal of the primary winding of the transformer T1. The diode D15 is connected in parallel with the SiGe transistor Q10.

The SiGe transistor Q10 generates a rectangular wave by switching the DC power supply input Vᵢₙ in response to a control signal supplied to the base thereof. The rectangular wave generated by the SiGe transistor Q10 is supplied to the primary winding of the transformer T1.

The diode D15 provides the protection for the SiGe transistor Q10; the diode D15 is turned on and allows a current to flow therethrough, when a reverse voltage is applied to the SiGe transistor Q10.

The capacitor C11 has two roles: the capacitor C11 functions as a smoothing capacitor for smoothing the DC power supply input Vᵢₙ. Moreover, the capacitor C11 operates as a energy source which supplies the a current to the SiGe transistor Q10 in order to compensate for delay of a current generated immediately after the turn-on of the SiGe transistor Q10 from the DC power supply to the SiGe transistor Q10, the delay occurring within the DC power supply and by the inductances in the wirings.

The transformer T1 receives the rectangular wave from the SiGe transistor Q10 at the primary winding, and outputs a rectangular wave with a voltage level corresponding to the transformation ratio from the secondary winding. The rectangular wave from the transformer T1 is supplied to the rectifying and smoothing circuit 102.

The rectifying and smoothing circuit 102 includes diodes D21 and D22, a reactor L21, a capacitor C21, output terminals 105 and 106 outputting a DC output voltage Vₒᵤₜ. The diodes D21 and D22 are used to rectify the rectangular wave from the transformer T1, and the reactor L21 and the capacitor C21 are used to smooth the rectified rectangular wave. More specifically, the diode D21 allows the rectangular wave current from the secondary winding of the transformer T1 to flow through the reactor L21 and the capacitor C21 when the SiGe transistor Q100 is at on-state. The diode D22 supplies the energy stored across the reactor L21 to the capacitor C21, and thereby smoothes the output voltage Vₒᵤₜ, when the SiGe transistor Q10 is at off-state. In the case where pulse output is requested as the output voltage Vₒᵤₜ, the capacitor C21 is often omitted.

As shown in Fig. 2B, in order to generate the DC output voltage from the AC power supply input, the input of the switching circuit 201 may be connected with the full-wave rectifier circuit 107 composed of diodes D11 to D14.

### Structure of SiGe Transistor

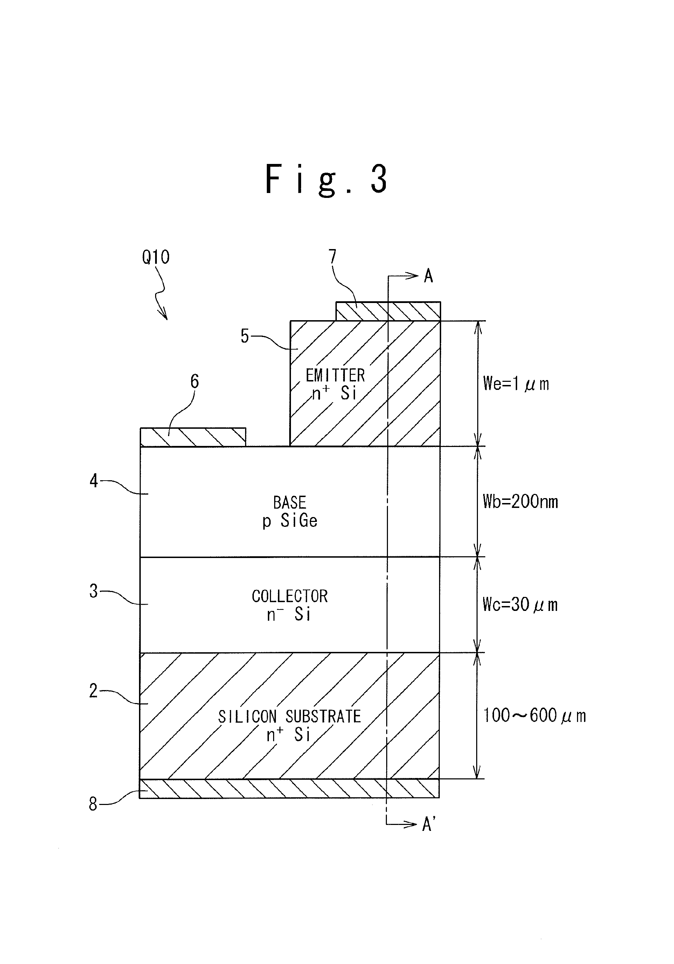

As described above, the optimization of structure of the SiGe transistor Q10 is important to for increasing an operating speed and reducing the collector-to-emitter voltage at on-state. Fig. 3 is a cross-sectional view showing a structure of the SiGe transistor Q10 in this embodiment. Basically, the SiGe transistor Q10 adopts the structure disclosed in United States Patent No. 6,423,989. The SiGe transistor Q10 includes a heavily doped N-type silicon substrate 2, a lightly doped N-type silicon collector layer 3 formed on the main surface of the N-type silicon substrate 2, a P-type base layer 4 formed on the N-type silicon collector layer 3, and a heavily doped N-type silicon emitter layer. The base layer 4 is composed of a Si layer positioned closer to the emitter layer 5 and a SiGe layer positioned closer to the collector layer 3. A collector electrode 8 is connected to the back surface of the Si substrate 2, a base electrode 6 is connected to the base layer 4, and an emitter electrode 7 is connected to the emitter layer 5.

To achieve a high withstand voltage, a low on-state voltage, and a high switching speed, the SiGe transistor Q10 is optimized in the thickness of the base layer 4, the thickness of the collector layer 3, and the Ge profile of the SiGe layer.

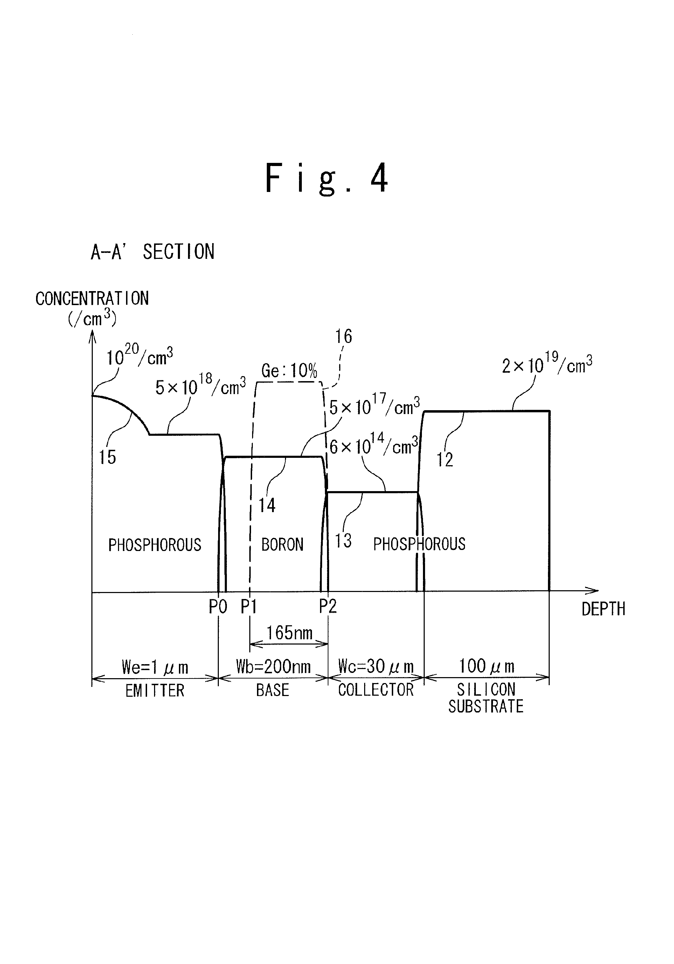

Fig. 4 is a graph showing dopant profiles and a preferable Ge profile on Section A-A' of Fig. 3. A line 12 represents the dopant profile of the N-type silicon substrate 2, and a line 13 represents the dopant profile of the collector layer 3. Also, a line 14 represents the dopant profile of the base layer 4, and a line 15 represents the dopant profile of the emitter layer 5. Finally, a dashed line 17 represents the Ge profile of the base layer 4.

The N-type silicon substrate 2 is heavily doped with phosphorus or arsenic as N-type dopants. The dopant concentration therein is preferably 1 x 10¹⁸ to 1 x 10²⁰ /cm³, and the thickness of the N-type silicon substrate 2 is preferably 100 to 500 µm. In this embodiment, the dopant concentration of the N-type silicon substrate 2 is 2 x 10¹⁹ / cm³ and the thickness thereof is 100 µm, as shown by the line 12 in Fig. 4.

The collector layer 3 is lightly doped with phosphorus or arsenic as N-type dopants. The dopant concentration therein is preferably 1 x 10¹⁴ to 5 x 10¹⁵ /cm³. In this embodiment, the dopant concentration of the collector layer 3 is 6 x 10¹⁴/cm³, as shown by the line 13 in Fig. 4.

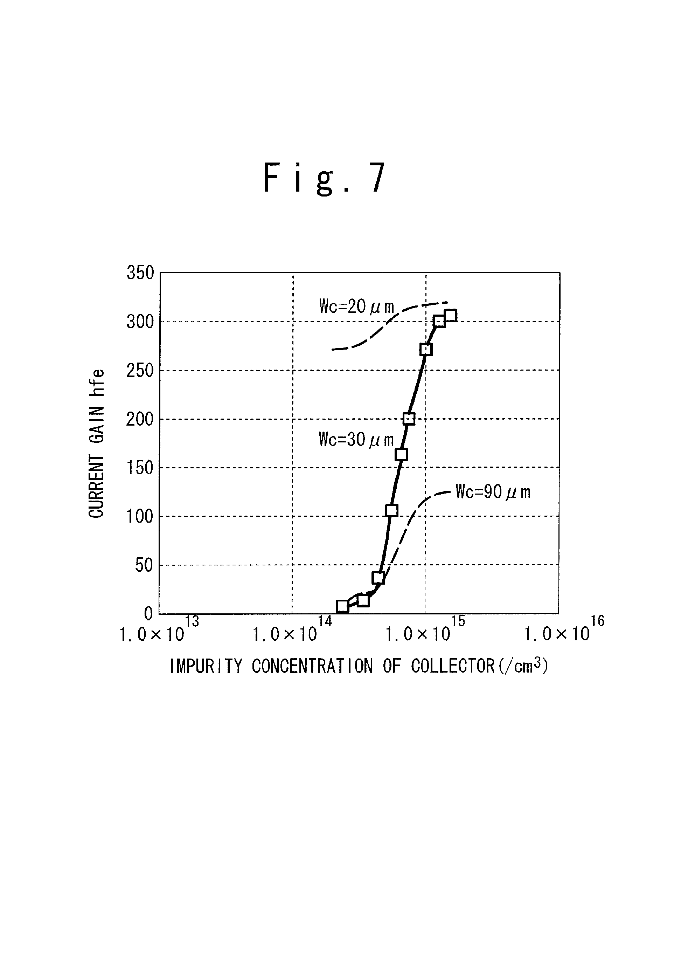

The thickness of the collector layer 3 is preferably 20 to 90 µm. The reason for that can be understood from Fig. 7 which presents a graph showing a relationship between the thickness of the collector layer 3 and a current gain h_{fe} in the case where the Ge concentration of the SiGe layer is 10% within the base layer 4. As shown in Fig. 7, it is not preferable that the thickness of the collector layer 3 is more than 90 µm, because that would decrease the current gain h_{fe} down to 100 or less. On the other hand, if the thickness of the collector layer 3 is less than 20 µm, a required withstand voltage cannot be achieved. In this embodiment, the thickness of the collector layer 3 is 30 µm.

The base layer 4 is doped with boron as P-type dopants. The dopant concentration thereof is preferably 1 x 10¹⁷ to 1 x 10¹⁸/cm³. In this embodiment, the dopant concentration of the base layer 4 is 5 x 10¹⁷/cm³ as shown by the line 14 in Fig. 4.

In this embodiment, the base layer 4 is composed of a Si layer positioned closer to the emitter layer 5 and a SiGe layer positioned closer to the collector layer 3. In other words, as shown by a dashed line 16 in Fig. 4, the Ge concentration of the base layer 4 is 0% from the boundary P0 between the emitter layer 5 and the base layer 4 to a position P1 inside the base layer 4, and is a value given specifically from the position P1 to the boundary P2 between the base layer 4 and the collector layer 3. The structure in which the Si layer with a long lifetime and high mobility is positioned on the emitter side, and the SiGe layer with a short lifetime and low mobility is positioned on the collector side would improve the transport factor of electrons that reach the collector layer 3 from the emitter layer 5, and thereby increase the current gain. However, a Ge profile cannot be increased or decreased in a stepwise manner in a real product, and thus the Ge profile of the base layer 4 comes to be tilted in concentration at the boundary portions of the SiGe layer; the Ge profile has the form of a trapezoid, for example, as shown in Fig. 4. The thickness of the SiGe layer, that is, the distance X_{sige} from the position P1 to the boundary P2 preferably ranges 20 to 380 nm. In this embodiment, the distance X_{sige} is 165 nm.

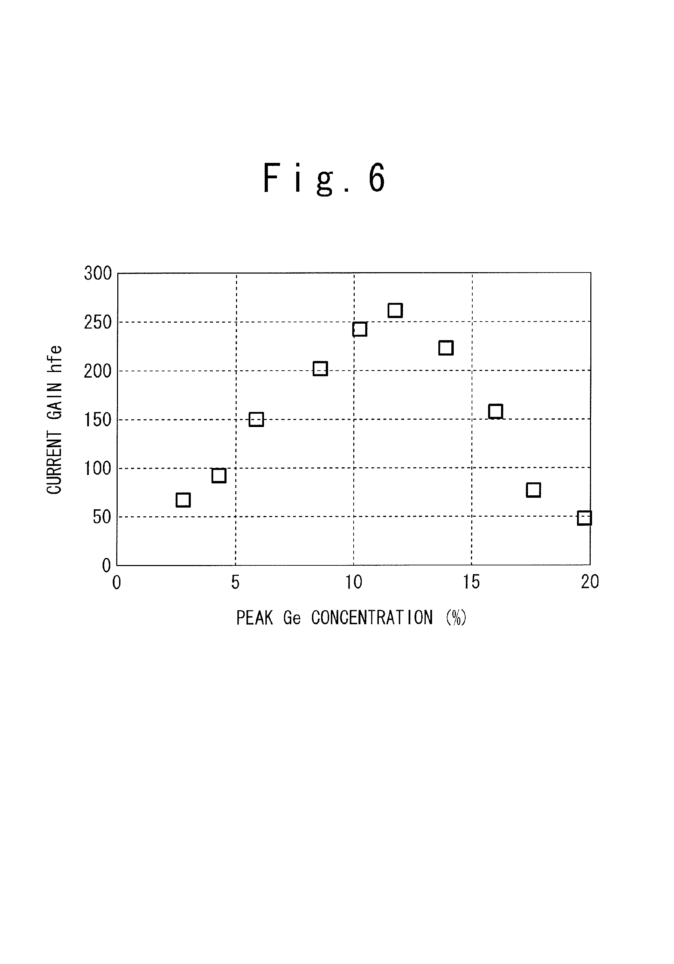

The Ge concentration in the SiGe layer (that is, the Ge concentration of the portion other than the boundary portions) is preferably 6 to 16 mol %. Fig. 6 is a graph indicating the relationship between the Ge concentration in the SiGe layer and the current gain h_{fe}. As shown in Fig. 6, a Ge concentration of 6 to 16 mol % increases the current gain h_{fe} more than 100. To raise the current gain h_{fe} more than 200, the Ge concentration is preferably 8 to 13 mol %.

The thickness of the base layer 4 (that is, the sum of the thicknesses of the Si layer and the SiGe layer which form the base layer 4) is preferably 100 to 400 nm. If the base layer 4 is thinner than 100 nm, the withstand voltage undesirably decreases. On the other hand, if the base layer 4 is thicker than 400 nm, the current gain h_{fe} is undesirably decreased.

The emitter layer 5 is heavily doped with phosphorus or arsenic as N-type dopants. The dopant concentration of the emitter layer 5 has a Gaussian distribution near the emitter electrode 7 and is a steady value near the base layer 4. The dopant concentration in the emitter layer 5 is 1 x 10²⁰/cm³ in the peak value and is 5 x 10¹⁸/cm³ at the boundary P0 between the emitter layer 5 and the base layer 4. The dopant profile in the portion near the emitter electrode 7 may have a trapezoidal distribution, not a Gaussian distribution. The thickness of the emitter layer 5 is preferably 0.5 to 2 µm. In this embodiment, the emitter layer 5 is 1 µm thick.

In another embodiment, the portion between the boundary P0 of the emitter layer 5 and the base layer 4 and the position P1 inside the base layer 4 may contain Ge. In other words, the base layer 4 includes a first SiGe layer positioned closer to the emitter layer 5 and a second SiGe layer positioned closer to the collector layer 3, and the Ge concentration of the first SiGe layer is lower than the Ge concentration of the second SiGe layer. Preferably, the Ge concentration in the portion ranging from the boundary P0 to the position P1 (i.e., the first SiGe layer positioned closer to the emitter layer 5) is 0% to 3%. In this embodiment, the Ge concentration between the position P1 and the boundary P2 is preferably 6 to 16%, more preferably, 8 to 13%.

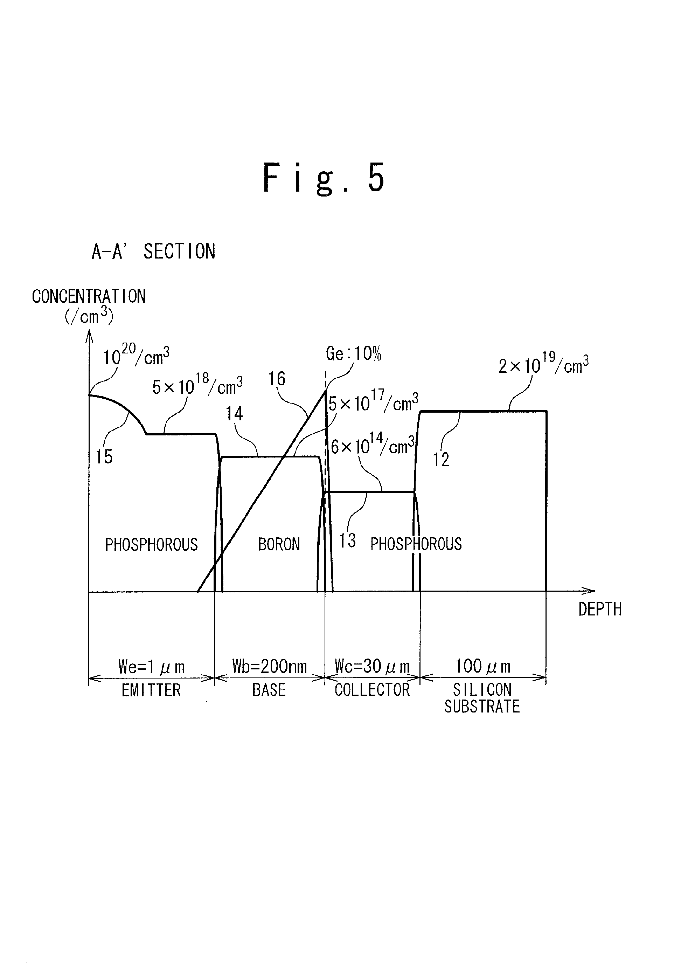

In still another embodiment, the base layer 4 may be composed of a SiGe layer with a sloped Ge profile, as shown in Fig. 5. In this embodiment, the Ge concentration in the base layer 4 increases according to the distance from the emitter layer 5; the Ge concentration in the base layer 4 has the minimum value at the boundary between the base layer 4 and the emitter layer 5, and has the maximum value at the boundary between the base layer 4 and the collector layer 3. The minimum value of the Ge concentration is preferably 0 to 3%. The maximum value of the Ge concentration is preferably 6 to 16%, more preferably, 8 to 13%. Such a Ge profile is effective in increasing the current gain. In this embodiment as well, the thickness of the base layer 4 is preferably 100 to 400 nm. In the embodiment of Fig. 5, the Ge concentration at the boundary between the base layer 4 and the emitter layer 5 is 2%, and the Ge concentration at the boundary between the base layer 4 and the collector layer 3 is 10%.

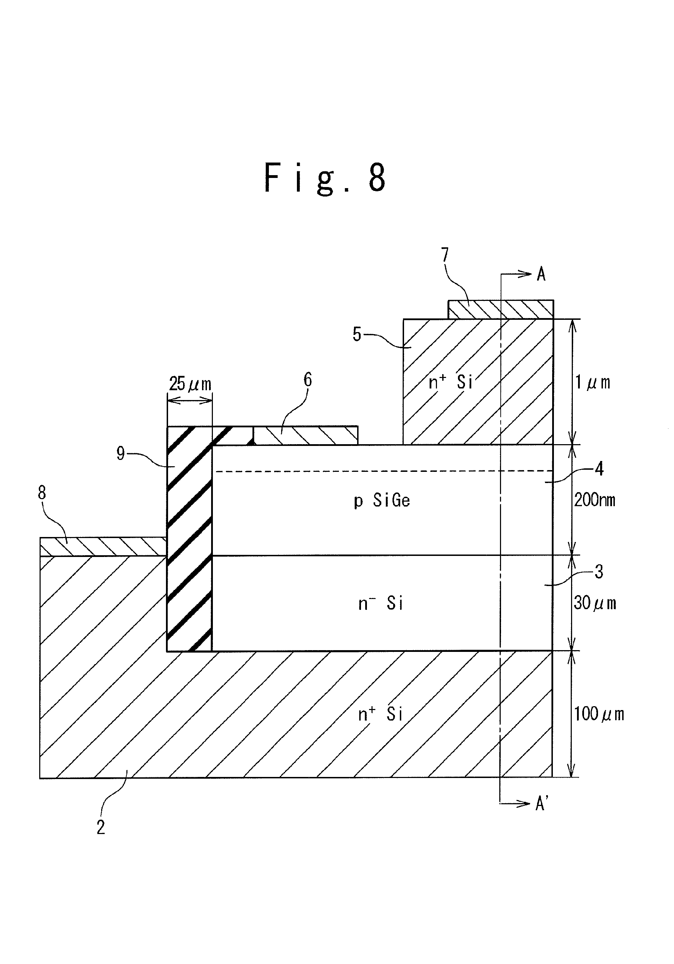

In still another embodiment, the SiGe transistor Q10 may adopt a planer structure as shown in Fig. 8, in place of the vertical structure shown in Fig. 3. In this case, the N-type silicon substrate 2 is partially etched, and the collector layer 3, the base layer 4, and the emitter layer 5 are formed on the etched portion. The collector electrode 8 is formed on the remaining non-etched portion. The collector electrode 8 is electrically insulated by an insulating layer 9 from the base layer 4 and the base electrode 6.

The performance of the SiGe transistor Q10 achieved by the above described structure optimization is as follows:
1) Rated current: 2.0A
2) Rated drain-to-source withstand voltage: 400V

1) Drain-to-source on-resistance: 400 mΩ
4) Turn-on time: 3 ns
5) Turn-off time: 3 ns
6) Current gain h_{fe}: 100 or more
It should be noted that the above performances are on condition of the bipolar transistor device area of 1 mm². The values of the on-resistance, turn-on time, turn-off time and current gain h_{fe} are on condition of the junction temperature of 100°C.

The above described structure optimization decreases the on-resistance down to 400 mΩ, thereby decreasing the on-voltage down to 0.4 V during switching an input current of 1 A. This effectively reduces a switching loss in the power converter.

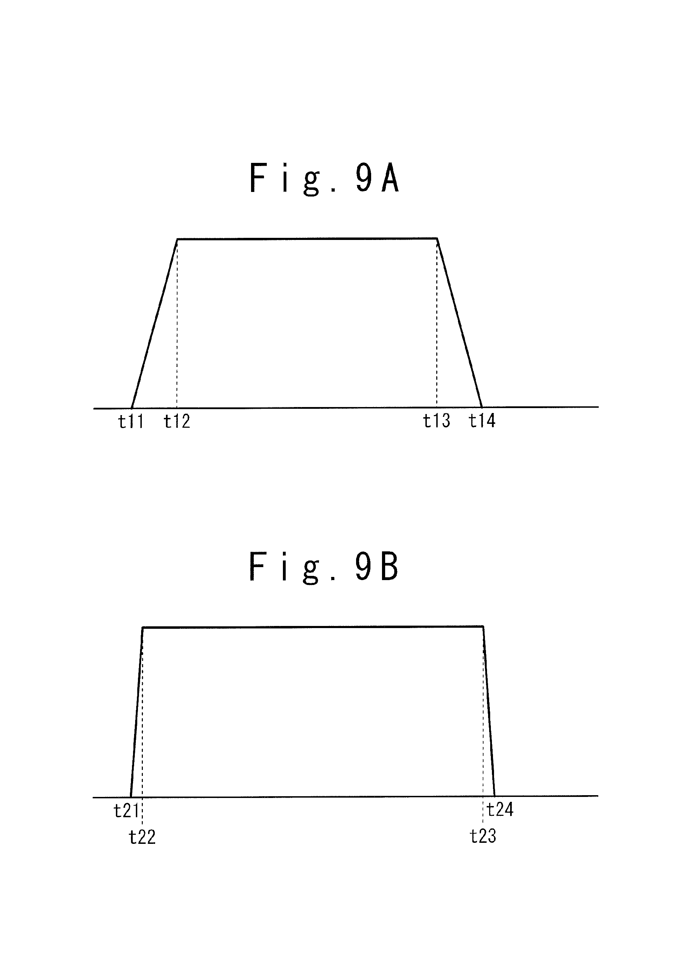

In addition to that, the above stated structure optimization reduces the turn-on time and the turn-off time down to 3 ns, resulting in effective reduction of the switching loss. Figs. 9A and 9B are graphs schematically depicting the current through a switching transistor. Fig. 9A is a graph in the case where the FET is used as a switching transistor, and Fig. 9B is a graph in the case where the above mentioned SiGe transistor is used as the switching transistor. As shown in Fig. 9A, if the FET is used as the switching transistor, the switching transistor requires a duration of 9.9 ns or more to switch from the off-state to the on-state; in Fig. 9A, the time t11 is the time when the current starts to rise, and the time t12 is the time when the rising of the current is completed. Besides, the switching transistor requires a duration of 11 ns or more to switch from the on-state to the off state; in Fig. 9A, the time t13 is the time when the current starts to fall, and the time t14 is the time when the fall of the current is completed.

Meanwhile, the adoption of the above described SiGe transistor reduces the turn-on time and the turn-off time down to 3 ns, the turn-on time being the time required for switching the switching transistor from the off-state to the on-state, and the turn-off time being the time required for switching the same from the off state to the on state. The reduction in the turn-on time and the turn-off time effectively reduces the loss within the transistor during the switching (that is, the time integral of the product of transient voltage and transient current). In addition, the adoption of the SiGe transistor decreases the on-voltage, thereby effectively reduces the loss within the switching transistor in the on state. Decreasing the loss within the switching transistor allows reducing the size and weight of the cooling mechanism of the switching transistor, such as aluminum cooling fins and a fan. This contributes to the downsizing of the power converter and the products equipped with it.

The reductions in the turn-on and turn-off times allow boosting the switching frequency. This permits the transformer, inductor and capacitor within the power converter to be downsized, which contributes to the reduction in size of the power converter. If a nanotechnology-applied metal/ferrite composite magnetic core is employed in the transformer for improving the high-frequency characteristics and reducing the loss, this allows increasing the switching frequency up to several MHz, which leads to further efficiency enhancement and size reduction.

The utility of the power converter in this embodiment will be more specifically described hereinafter, with considerations given to specifications required by AC adapters or battery chargers for cellular phones, notebook computers and so on.

Below presented are comparisons in the on-state loss, the turn-on loss, and the turn-off loss of the switching transistor, between the case where the FET is used as the switching transistor and the case where the SiGe transistor is used as the switching transistor. The specifications of the power converter are on the assumption that the input voltage Vᵢₙ is DC 135 V (this is the average DC voltage obtained by rectifying the 100-V AC voltage.), the output voltage is 10 V, and the power supply capacity is 100 W. In this case, the magnitude of the current to be switched by the switching transistor is about 1 A in peak value. Additionally, the switching frequency is set to be 1 MHz in consideration of the current technological trends.

If the FET is used as the switching transistor, the loss in the switching transistor is 2.27 W in total; for a breakdown, the on-state loss is 1.8 W, the turn-on loss is 0.2W, and the turn-off loss is 0.25 W.

On the other hand, if the SiGe transistor mentioned above is used as a switching transistor, the loss in the switching transistor is 0.34 W in total. For a breakdown, the on-state loss is 0.2 W, the turn-on loss is 0.07 W, and the turn-off loss is 0.07 W. The usage of the SiGe transistor decreases the loss by 1.93W.

The loss reduction of 1.93W has an extreme significance. For instance, assuming that the power converter of this embodiment is applied to all AC adapters for notebook computers, about 170 million notebook computers were manufactured in 2002 and thus energy of 328.1 thousand kW would have been saved. The power converter of this embodiment has the potential to achieve overall energy saving of several million kW because it can be applied to many other products, for example, battery chargers for cellular phones, and power supplies for liquid crystal display TVs, OA equipment, and lighting fixtures.

The present invention is described with use of various embodiments, but this does not intend that the present invention is limited to these embodiments. It is self-evident to those skilled in the art that alterations are possible within a range of the claims.

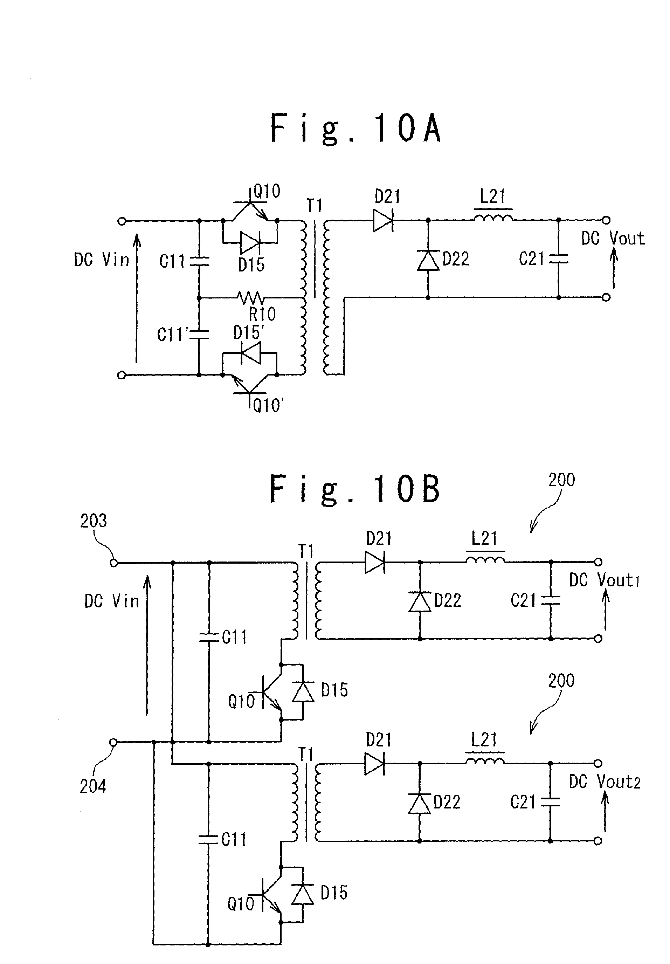

In particular, it is to be noted that the present invention may be also applied to power converters employing other circuit topologies, for example, flyback converters and LCC topologies. As shown in Fig. 10A, for instance, the SiGe transistors may be used as switching transistors for a two-transistor forward converter; in Fig. 10A, the SiGe transistors are denoted by numerals Q10 and Q10'. If a plurality of switching transistors are used, as in the case with a two-transistor forward converter, the SiGe transistor may be used for all the transistors therein may be composed of, or for only some of the transistors. Moreover, as shown in Fig. 10B, the present invention may be applied to a power conversion unit which includes a plurality of power converters sharing the external DC input Vᵢₙ; in Fig. 10B, a plurality of power converters 200 are connected to the input terminals 203 and 204 receiving the external DC input Vᵢₙ. The outputs of the power converters 200 are denoted by symbols Vₒᵤₜ₁ and Vₒᵤₜ₂.

## Claims

1. A power converter comprising:
a switching circuit including a bipolar transistor for switching a DC power input,
wherein a base layer of said bipolar transistor includes a SiGe layer.

2. The power converter according to claim 1, further comprising:
a rectifier circuit; and
a transformer having a primary winding connected to said switching circuit and a secondary winding connected to said rectifier circuit.

3. The power converter according to claim 2, wherein further comprising:
another rectifier circuit receiving an AC power input to output said DC power input.

4. The power converter according to claim 2, wherein said switch circuit receives an input terminal receiving said DC power input, and
wherein said bipolar transistor is disposed between said primary winding and said input terminal, and provides an electrical connection between said primary winding and said input terminal in response to a control signal.

5. The power converter according to any one of claims 1 to 4, wherein said base layer further includes a Si layer, and
wherein said SiGe layer is installed between said Si layer and a collector layer of said bipolar transistor.

6. The power converter according to claim 5, wherein said SiGe layer has a Ge concentration of 6 to 16 mol %.

7. The power converter according to claim 6, wherein said base layer has a thickness of 100 to 400 nm.

8. The power converter according to claim 6, wherein said collector layer has a thickness of 20 to 90 nm.

9. The power converter according to any one of claims 1 to 4, wherein said SiGe layer comprises:
a first SiGe layer connected to an emitter layer of said bipolar transistor, and
a second SiGe layer disposed between said first SiGe layer and a collector layer of said bipolar transistor, and
wherein said first SiGe layer has a Ge concentration lower than that of said second SiGe layer.

10. The power converter according to claim 9, wherein the Ge concentration of said second SiGe layer ranges from 6 to 16 mol %.

11. The power converter according to claim 10, wherein said base layer has a thickness of 100 to 400 nm.

12. The power converter according to claim 10, wherein said collector layer has a thickness of 20 to 90 nm.

13. The power converter according to claim 1, wherein a Ge concentration of said SiGe layer increases with distance from an emitter layer of said bipolar transistor.

14. The power converter according to claim 13, wherein a peak value of said Ge concentration of said SiGe layer ranges from 6 to 16 mol %.

15. The power converter according to claim 14, wherein said base has a thickness of 100 to 400 nm.

16. The power converter according to claim 14, wherein said collector layer has a thickness of 20 to 90 nm.

17. The power converter according to any one of claims 1 to 16, further comprising:
a diode connected between a collector and an emitter of said bipolar transistor.

18. A power converting unit comprising:
an external input terminal receiving an external power input; and
a plurality of power converters according to claims any one of claims 1 to 17,
wherein said plurality of power converters are commonly connected to said external input terminal.
